(19) Europäisches Patentamt
European Patent Office
Office européen des brevets

(11) **EP 2 189 825 A1**

(12) **EUROPEAN PATENT APPLICATION**
published in accordance with Art. 153(4) EPC

(43) Date of publication:
**26.05.2010 Bulletin 2010/21**

(51) Int Cl.:
***G02B 6/122*** *(2006.01)*     ***G02B 6/42*** *(2006.01)*

(21) Application number: **08832655.8**

(22) Date of filing: **03.09.2008**

(86) International application number:
**PCT/JP2008/065888**

(87) International publication number:
**WO 2009/037976 (26.03.2009 Gazette 2009/13)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **20.09.2007 JP 2007244311**

(71) Applicant: **Omron Corporation**
**Kyoto-shi, Kyoto 600-8530 (JP)**

(72) Inventors:
• **KASAI, Masaaki**
 **Kyoto 600-8530 (JP)**

• **HOSOKAWA, Hayami**
 **Kyoto 600-8530 (JP)**
• **YASUDA, Naru**
 **Kyoto 600-8530 (JP)**
• **SAMESHIMA, Hiroshi**
 **Kyoto 600-8530 (JP)**
• **TATARA, Yoshitaka**
 **Kyoto 600-8530 (JP)**
• **YOSHITAKE, Naoki**
 **Kyoto 600-8530 (JP)**

(74) Representative: **Giovannini, Francesca**
 **Osha Liang**
 **32, avenue de l'Opéra**
 **75002 Paris (FR)**

(54) **OPTICAL WIRING ARRANGEMENT AND OPTICAL TRANSMISSION MODULE**

(57) To satisfy a mobility required in an application to a wiring in an electronic device, and reduce breakage, scraping, and abrasion due to contact with an external structural body, an optical wiring (4) of the present invention is an optical wiring mounted on an electronic device, the optical wiring including a light transmission path (9) for transmitting an optical signal, wherein a lubricating layer (10) that reduces friction generated when coming in contact with a structural body (11) in the electronic device to lower than when the light transmission path (9) comes in contact with the structural body (11), and that bends according to deformation of the light transmission path (9) is arranged

Fig. 1

**Description**

TECHNICAL FIELD

The present invention relates to an optical wiring for transmitting optical signals, and a light transmission module.

BACKGROUND ART

In recent years, an optical communication network enabling large capacity data communication at high speed is expanding. The optical communication network is expected to be mounted to commercial-off-the-shelf devices. The optical wiring is demanded to be used no different from the current electric cable as an inter-substrate wiring for higher speed and larger capacity of data transfer, noise countermeasures, and data transmission between substrates in a device. Such optical wiring includes an optical fiber, and a plastic optical fiber (POF).

Conventionally, an optical cable that can be fabricated through a processing method suited for the application of long distance data transmission such as the optical fiber or the plastic optical fiber is mainly adopted for the inter-substrate wiring. The conventional inter-substrate wiring adopts a covering structure of protecting the periphery with a covering layer to prevent degradation of characteristics due to mechanical impact from the outside.

A film light guide is suited for obtaining an optical function since it can be fabricated through a processing method in which any material and pattern can be used. Thus, the light guide has been mainly directed to optical circuit application. The light guide is formed by a core having a large index of refraction and a clad having a small index of refraction arranged in contact with the periphery of the core, and propagates the optical signal that entered the core while repeating total reflection at the boundary of the core and the clad. The film light guide has flexibility as the core and the clad are made of flexible polymeric materials.

For such film light guide, Patent Document 1 discloses a film light guide in which the main surface of the clad is covered with a protective layer consisting of oxide, nitride, or oxynitride.

While large capacity data communication at high speed is being demanded, an electric-light transmission integrated module in which the transmission by a conventional electric wiring and transmission by an optical wiring coexist has been proposed. Such electric-light transmission integrated module adopts an electric/light co-mounted substrate that uses a light guide as one part of the inter-substrate wiring.

In the electric/light co-mounted substrate, it is difficult that the layer of the electric wiring is used as the substrate and a layer of the optical wiring is stacked thereon. Furthermore, forming the layer of the electric wiring and the layer of the optical wiring on the same plane is difficult due to the formation of the light guide. Thus, the electric/light co-mounted substrate has a multi-layer structure in which the number of stacking is relatively large.

A technique for enhancing the flexibility of the electric/light co-mounted substrate is disclosed in Patent Document 2. Patent Document 2 describes a technique of separating (spacing apart) the optical wiring and the electric wiring only at the bent portion of the electric/light co-mounted substrate, and forming a space (air layer) between the wirings. The total thickness of the electric/light co-mounted substrate thus can be reduced. Furthermore, a technique of planarly shifting the optical wiring and the electric wiring so that the optical wiring and the electric wiring do not overlap in the electric/light co-mounted substrate is described. Such technique is an application of the technique performed not only in the electric/light co-mounted substrate but also in the normal electric wiring.

In recent years, shorter distance in the data transmission distance and smaller space are demanded on the inter-substrate wiring with development in electronic devices such as a portable telephone and a personal computer. Accompanied therewith, a region where mobility such as bend and twist is given importance is being focused in the inter-substrate wiring of the electronic device. The mobility required in the application to the wiring in the electronic device is difficult to be satisfied with the bendability of the conventional inter-substrate wiring.

Since the film light guide is fabricated through a processing method in which any material and pattern can be used, a flexible material can be used for the material. Thus, the single body of the film light guide can satisfy the mobility required in the application to the wiring in the electronic device.

However, if the film light guide is actually applied to the inter-substrate wiring of the electronic device, the following problems arise since the film light guide is the flexible optical wiring. In other words, when the film light guide serving as the inter-substrate wiring is mounted in the electronic device, the film light guide may contact with a structural body exterior to the film light guide. With such contact, the degradation of the optical characteristics is more susceptible than the conventional inter-substrate wiring. The film light guide may be also broken, scraped, or abraded in contact with the external structural body.

Similar to the conventional inter-substrate wiring, the following problems arise even when a covering structure of covering the periphery (both surfaces, entire surface) with the covering layer is adopted with respect to the film light guide. In other words, in the film light guide having the covering structure, the bending elasticity is controlled to the bending elasticity of the covering layer regardless of how much bendability and flexibility are provided to the film light guide. As a result, the film light guide serving as the inter-substrate wiring becomes considerably hard to bend, and the mobility required in the application to the wiring in the electronic device becomes difficult to be satisfied.

Furthermore, in the technique of separating (spacing apart) the optical wiring and the electric wiring and forming a space (air space) between these wirings as in Patent Document 2, the following problems unique to the optical wiring that cannot be anticipated in the technique performed in the normal electrical wiring arise.

When forming the light guide focusing on the bendability in the electric/light co-mounted substrate, the leakage light at the time of bending reduces as opposed to the electric wiring in which the PI (polyimide) is the main material, and thus the difference in index of refraction between the core and the clad needs to be made large. In selecting the material of the clad, a more flexible material is demanded to withstand shearing at the time of bending in addition to making the difference in index of refraction with the core large.

In the conventional light guide for optical communication, the difference in index of refraction between the clad and the core needs to be very small and precisely controlled, and hence clad is realized by adding additive to the core. In other words, the main component of the material is the same in the core and the clad. When the light guide is used for the optical wiring of the electric/light co-mounted substrate (inter-substrate wiring), the range of selections increases as the clad does not need to be formed by adding additive to the core as in the conventional light guide for optical communication, and various materials used in industrial products up to now can be considered as candidates for the material of the clad.

If a flexible resin is consequently selected for the material of the clad, the resin often has tack property. Thus, even if the space (air layer) is formed between the optical wiring and the electric wiring as in Patent Document 2, the electric wiring comes in contact with the optical wiring at the time of bending and attach to each other (although an adhesive layer is not provided) since the optical wiring surface has tack property.

Furthermore, in the configuration in which the space (air layer) is formed between the optical wiring and the electric wiring as in Patent Document 2, the clad in the light guide is exposed to air. Thus, the light leaked from the core at the time of bending the light guide may be confined inside the clad, and propagated to the end of the light guide. As a result, the leakage light leaked out from the clad at the end of the light guide couples with the light receiving element, and becomes a cause of false operation of the light transmission module. The leakage light propagating inside the clad has a light path difference with respect to the signal light propagating through the core, and thus the received signal waveform may be distorted.

Patent Document 1: Japanese Laid-Open Patent Publication No. 2005-156882 (published on June 16, 2005)
Patent Document 2: Japanese Laid-Open Patent Publication No. 2006-284925 (published on October 19, 2006)

DISCLOSURE OF THE INVENTION

The present invention has been devised to solve the problems described above, and an object thereof is to provide an optical wiring and a light transmission module that satisfies the mobility required in the application to the wiring in the electronic device, and that reduces breakage, scraping, and abrasion due to contact with the external structural body.

In order to solve the above problems, an optical wiring according to the present invention is **characterized in that** an optical wiring mounted on an electronic device, the optical wiring including a light transmission path for transmitting an optical signal, wherein a function layer that reduces friction generated when coming in contact with a structural body in the electronic device to lower than when the light transmission path comes in contact with the structural body, and that bends according to deformation of the light transmission path is arranged.

According to the above configuration, the function layer contacts with the structural body in the electronic device when the light transmission path in the electronic device moves. The light transmission path is thus prevented from coming in contact with the structural body. The function layer reduces the friction generated when coming in contact with the structural body to lower than when the light transmission path comes in contact with the structural body. Thus, the light transmission path moves so as to slide on the structural body in the electronic device. The breakage, scarping, and abrasion of the optical wiring due to contact with the structural body are thereby reduced, and the optical characteristics are less likely to degrade. The bendability and the twisting property of the light transmission path can be maintained since the function layer bends according to the deformation of the light transmission path.

Therefore, according to the above configuration, the optical wiring that satisfies the mobility required in the application to the wiring in the electronic device and that reduces breakage, scraping, and abrasion due to contact with the external structural body can be realized.

In order to solve the above problems, a light transmission module according to the present invention is **characterized in that** a light transmission module including the above optical wiring, the light transmission module including a first substrate mounted with a first optical element for converting an electric signal to an optical signal, and a second substrate mounted with a second optical element for converting an optical signal to an electric signal, wherein the optical wiring optically couples with the first and the second optical elements, and transmits the optical signal between the first and the second substrates.

According to the above configuration, the light transmission module that satisfies the mobility required in the application to the wiring in the electronic device and that reduces breakage, scraping, and abrasion due to contact with the external structural body can be realized.

Further objects, characteristics, and advantages of the present invention will be sufficiently understood by reference to the following description.

BRIEF DESCRIPTION OF THE DRAWINGS

FIG. 1 is a side view showing a schematic configuration of an optical wiring according to one embodiment of the present invention.

FIG. 2 is a view showing a schematic configuration of a light transmission module according to the present embodiment.

FIG. 3 is a view schematically showing a light transmission state in the optical wiring.

FIGS. 4(a) to 4(c) show one example of a configuration of a light guide serving as a light transmission path, where FIG. 4(a) is a side view, FIG. 4(b) is a cross-sectional view, and FIG. 4(c) is a perspective view.

FIGS. 5(a) and 5(b) show one example of the configuration of the optical wiring serving as variant 1-1, where FIG. 5(a) is a cross-sectional view and FIG. 5(b) is a plan view.

FIG. 6 is a cross-sectional view showing another variant of the optical wiring of FIG. 5.

FIGS. 7(a) and 7(b) show one example of the configuration of the optical wiring serving as variant 1-2, where FIG. 7(a) is a side view and FIG. 7(b) is a plan view.

FIG. 8 is a plan view showing one example of the configuration of the optical wiring serving as variant 1-3.

FIG. 9 is a plan view showing one example of the configuration of the optical wiring serving as variant 1-4.

FIGS. 10(a) and 10(b) show one example of the configuration of the optical wiring serving as variant 1-5, where FIG. 10(a) is a plan view and FIG. 10(b) is a cross-sectional view taken along line CC'.

FIG. 11 is a cross-sectional view showing one example of the configuration of the optical wiring serving as variant 2.

FIG. 12 is a cross-sectional view showing still another variant of the optical wiring of FIG. 11.

FIGS. 13(a) and 13(b) show one example of the configuration of the optical wiring serving as variant 3, where FIG. 13(a) is a plan view and FIG. 13(b) is a cross-sectional view taken along line CC'.

FIG. 14 is a cross-sectional view showing one example of the configuration of the optical wiring serving as variant 4.

FIG. 15 is a cross-sectional view showing one example of the configuration of the optical wiring serving as variant 5.

FIG. 16 is a cross-sectional view showing one example of the configuration of the optical wiring serving as variant 6.

FIGS. 17(a) and 17(b) show one example of the configuration of the optical wiring serving as variant 7, where FIG. 17(a) is a plan view and FIG. 17(b) is a cross-sectional view.

FIGS. 18(a) and 18(b) show one example of the configuration of the optical wiring serving as variant 8, where FIG. 18(a) is a cross-sectional view and FIG. 18(b) is a cross-sectional view in which one part of the optical wiring is enlarged.

FIG. 19 is a side view showing one example of the configuration of the optical wiring serving as variant 9.

FIG. 20(a) is a perspective view showing an outer appearance of the foldable portable telephone incorporating the optical wiring according to the present invention, FIG. 20(b) is a block diagram of a portion where the optical wiring is applied in the foldable portable telephone shown in FIG. 20(a), and FIG. 20(c) is a perspective plan view of the hinge portion in the foldable portable telephone shown in FIG. 20(a).

FIG. 21(a) is a perspective view showing an outer appearance of a printing device including the optical wiring according to the present embodiment, FIG. 21(b) is a block diagram showing the main parts of the printing device shown in FIG. 21(a), and FIG. 21(c) and FIG. 21(d) are perspective views showing a curved state of the light guide when a printer head is moved (driven) in the printing device.

FIG. 22 is a perspective view showing an outer appearance of a hard disc recording and reproducing device including the optical wiring according to the present embodiment.

FIG. 23 is a schematic view showing the application area of the optical wiring of the present embodiment in the foldable portable telephone.

FIG. 24 is a perspective view showing a schematic configuration of an integrated module.

FIG. 25(a) is a functional diagram showing another configuration example of the integrated module, and FIG. 25(b) is a side view showing one example of the configuration of the integrated module shown in FIG. 25(a).

FIGS. 26(a) to 26(c) schematically show a movable (deformation) example of the optical wiring in the integrated module, where FIG. 26(a) is a side view showing a movable example of a case where both the optical wiring and the electrical wiring are bent, FIG. 26(b) is a cross-sectional view showing a movable example of the optical wiring when the electrical wiring is twisted, and FIG. 26(c) is a side view showing a movable example of the optical wiring of a case where the electrical wiring is sled.

DESCRIPTION OF SYMBOLS

| 1 | light transmission module |
|---|---|
| 2 | light transmission processing unit |
| 3 | light reception processing unit |
| 4 | optical wiring |
| 5 | light emitting drive portion |
| 6 | light emitting portion |
| 7 | amplifier |
| 8 | light receiving portion (optical element) |
| 9 | light transmission path |
| 9 | copposing surface |
| 10 | lubricating layer (functional layer) |
| 10a | planar surface |
| 10b | concave portion |
| 10c | convex portion |
| 10d | slit |
| 10e | concave portion |
| 10f | convex portion |
| 10' | primer layer |
| 11 | structural body |
| 12 | light guide |
| 12a | concave portion |
| 12b | convex portion |
| 12c | light path conversion mirror surface |
| 13 | core |
| 14 | clad |

13a, 14a    contacting surface

13b, 14b    surface

15    electrical wiring

16    mounting outer unit

17    substrate

18    package

BEST MODE FOR CARRYING OUT THE INVENTION

One embodiment of the present invention will be described below based on the drawings.

(Configuration of light transmission module)

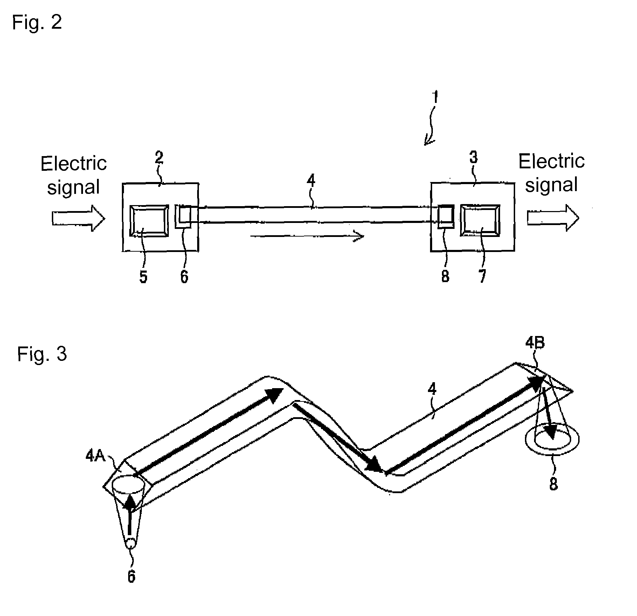

FIG. 2 shows a schematic configuration of a light transmission module 1 according to the present embodiment. As shown in the figure, the light transmission module 1 includes a light transmission processing unit 2, a light reception processing unit 3, and an optical wiring 4.

The light transmission processing unit 2 has a configuration including a light emitting drive portion 5 and a light emitting portion 6. The light emitting drive portion 5 drives the light emission of the light emitting portion 6 based on an electrical signal inputted from the outside. The light emitting drive portion 5 is configured by a light emission drive IC (Integrated Circuit). Although not shown in the figure, the light emitting drive portion 5 includes an electrical connecting part with respect to an electrical wiring for transmitting the electrical signal from the outside.

The light emitting portion 6 emits light based on a drive control by the light emitting drive portion 5. The light emitting portion 6 is configured by a light emitting element such as VCSEL (Vertical Cavity-Surface Emitting Laser). A light incident side end of the light wiring 4 is irradiated with the light emitted from the light emitting portion 6 as a light signal.

The light reception processing unit 3 has a configuration including an amplifier 7 and a light receiving portion 8. The light receiving portion 8 receives the light serving as a light signal exited from a light exit side end of the light wiring 4, and outputs an electrical signal through photoelectric conversion. The light receiving portion 8 is configured by a light receiving element such as PD (Photo-Diode).

The amplifier 7 amplifies the electric signal outputted from the light receiving portion 8 and outputs the same to the outside. The amplifier 7 is configured by amplification IC, for example. Although not shown, the amplifier 7 includes an electrical connecting part with respect to the electrical wiring for transmitting the electrical signal to the outside.

The light wiring 4 is a medium for transmitting the light exited from the light emitting portion 6 to the light receiving portion 8. The details of the configuration of the optical wiring 4 will be described later.

FIG. 3 is a view schematically showing the state of light transmission in the light wiring 4. As shown in the figure, the light wiring 4 is configured by a column-shaped member having flexibility. A light incident surface 4A is arranged at the light incident side end of the light wiring 4, and a light exit surface 4B is arranged at the light exit side end.

The light exited from the light emitting portion 6 enters from a direction perpendicular to the light transmission direction of the light wiring 4 with respect to the light incident side end of the light wiring 4. The incident light advances through the light wiring 4 by being reflected at the light incident surface 4A. The light that advances through the light wiring 4 and reaches the light exit side end is reflected at the light exit surface 4B and exits in a direction perpendicular to the light transmission direction of the light wiring 4. The light receiving portion 8 is irradiated with the exited light, and photoelectric conversion is performed in the light receiving portion 8.

According to such a configuration, the light emitting portion 6 serving as a light source can be arranged in a horizontal direction with respect to the light transmission direction with respect to the light wiring 4. Thus, if the light wiring 4 needs to be arranged parallel to the substrate surface, the light emitting portion 6 is installed between the light wiring 4 and the substrate surface so as to emit light in the normal direction of the substrate surface. With such a configuration, the mounting becomes easier than the configuration of installing the light emitting portion 6 so as to emit light parallel to the substrate surface. Such configuration facilitates mounting compared to the configuration of installing the light emitting portion 6 so as to emit light parallel to the substrate surface, and can be more miniaturized in regards to the configuration. This is because in the general configuration of the light emitting portion 6, the size in the direction perpendicular to the direction of emitting the light is greater than the size in the direction of emitting the light. Furthermore, application can be made to the configuration of using a plane mounting light emitting element in which the electrode and the light emitting portion are in the same plane.

The light transmission module 1 of the present embodiment has a configuration of guiding the signal light propagated through the optical wiring 4 to the light receiving portion 8 by reflecting at the light exit surface 4B (i.e., configuration using the light exit surface 4B as the reflection surface for converting the optical path), but the configuration of the light transmission module 1 is not limited to such configuration and the signal light exit from the light exit surface 4B merely needs to be receivable by the light receiving portion 8. For instance, the optical wiring 4 may be configured such that the light exit surface 4B does not function as the reflection surface, and the signal light is exited in the light transmitting direction from the light exit surface 4B. In this case, the light receiving portion 8 is arranged so that the light receiving surface is perpendicular to the substrate surface (i.e., direction perpendicular to the light transmitting direction), and receives the signal light exited in the light transmitting direction from the light exit surface 4B.

(Configuration of optical wiring)

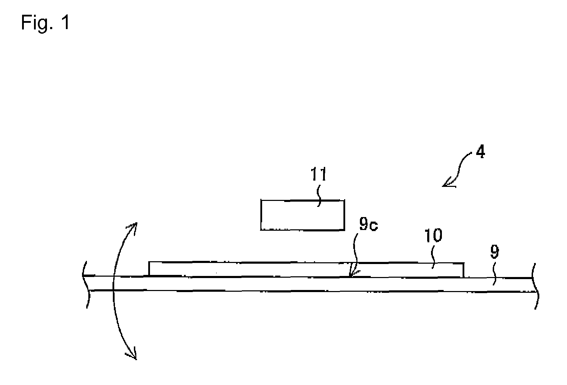

FIG. 1 is a side view showing a schematic configuration of the optical wiring 4. The optical wiring 4 is an optical wiring that can be mounted in the electronic device. As shown in the figure, the optical wiring 4 includes a light transmission path 9 for transmitting the optical signal. The light transmission path 9 includes a lubricating layer (functional layer) 10. The lubricating layer 10 has a function of reducing the friction that occurs at the time of coming in contact with the structural body 11 in the electronic device to lower than at the time that the light transmission path 9 comes in contact with the structural body 11, and is flexible (movable) according to the movement of the light transmission path 9. It is arranged on a surface including the opposing surface 9c with the structural body 11 in the light transmission path 9.

According to the configuration shown in FIG. 1, the lubricating layer 10 comes in contact with the structural body 11 when the light transmission path 9 in the electronic device moves in the direction of the arrow. The light transmission path 9 is then prevented from coming in contact with the structural body 11. The lubricating layer 10 can reduce the friction that occurs at the time of coming in contact with the structural body 11. The light transmission path 9 thus slidably moves the structural body 11 in the electrical device. The light transmission path 9 is thus reduced with breakage, scraping, and abrasion due to contact with the structural body 11, and degradation of the optical characteristics is less likely to occur.

The lubricating layer 10 is movable according to the movement of the light transmission path 9, and thus bendability and twisting property of the light transmission path 9 can be maintained. In particular, when mounted in the mobile device such as the portable telephone, ultra-flexibility of a level of lower than or equal to R = 4 mm is demanded on the light transmission path 9. With this, ultra-flexibility of a level of lower than or equal to R = 4 mm is also demanded on the lubricating layer 10.

The structure and the material of the lubricating layer 10 are not limited as long as the condition for maintaining the bendability and the twisting property of the light transmission path 9 can be satisfied. The material for constituting the lubricating layer 10 may be an organic material or a metal material.

Assuming the film thickness of the lubricating layer 10 is d and the distortion at the time of bending at the center of the film thickness is zero, the center length $x_0$ of the lubricating layer 10 at the time of linear line can be expressed with the following equation (1).

$$X_0 = \pi (R-d/2) \qquad (1)$$

Where R: bending diameter at the time of bending.
The outer peripheral length x of the lubricating layer 10 at the time of bending is expressed with the following equation (2).

$$X = \pi R \qquad (2)$$

Thus, the stretch $\Delta x$ of the outer periphery at the time of bending the lubricating layer 10 is expressed with the following equation (3).

$$\Delta x = x - x_0 = \pi d/2 \qquad (3)$$

The distortion $\varepsilon$ of the outer periphery at the time of bending the lubricating layer 10 is expressed with the following equation (4).

$$\varepsilon = \Delta x / x_0 = \pi d(2\pi R - \pi d) \qquad (4)$$

Thus, the stress $\delta$ generated at the time of bending the lubricating layer 10 is expressed with the following equation (5).

$$\delta = \varepsilon E \qquad (5)$$

Where E is the Young's modulus or the elasticity of the lubricating layer 10.

In the optical wiring 4, if the tensile strength of the lubricating layer 10 is greater than the stress $\delta$ expressed in equation (5), it can be said that the lubricating layer 10 has satisfactory bendability. Thus, the bendability tends to degrade the lower the tensile strength. The bendability tends to be lower the higher the Young's modulus or the elasticity E.

In view of such tendency, if the material constituting the lubricating layer 10 is an organic material, the material is preferably a flexible material in which the tensile strength is greater than or equal to 50 MPa and the elasticity is smaller than or equal to 6500 MPa or smaller than or equal to 80 times the tensile strength to satisfy the ultra-flexibility of the level of lower than or equal to R = 4 mm. If the material constituting the lubricating layer 10 is an organic material, materials such as polyimide (PI), polyethylene naphthalate (PEN), polyethylene terephthalate (PET), polyamide (PA), polycarbonate (PC), and the like may be used for the material. The thickness of the lubricating layer 10 is preferably smaller than or equal to 700 $\mu$m.

If the material constituting the lubricating layer 10 is a metal material, a material in which the tensile strength is greater than or equal to 100 MPa and the Young's modulus is smaller than or equal to 2000 GPa to satisfy the ultra-flexibility of the level of lower than or equal to R = 4 mm. If the material constituting the lubricating layer 10 is a metal material, materials such as gold, platinum, silver, copper, aluminum, phosphor bronze, and the like may be used for the material. The thickness of the lubricating layer 10 is preferably smaller than or equal to 70 $\mu$m.

The configuration of the light transmission path 9 is not particularly limited as long as the optical signal can be transmitted and the mobility required in the application to the wiring in the electronic device is satisfied. For instance, the light transmission path 9 preferably satisfies the ultra-flexibility of the level of lower than or equal to R = 4 mm when applied to the wiring in the mobile device such as a portable telephone as the electronic device.

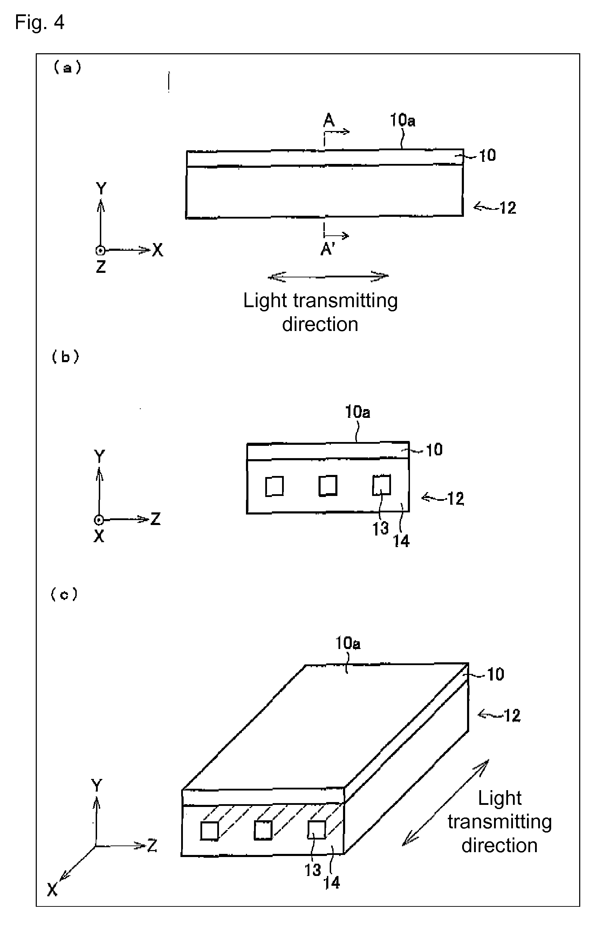

The light transmission path 9 that satisfies the mobility required in the application to the wiring in the electronic device includes the film light guide. The configuration of the light transmission path when the film light guide is adopted for the light transmission path will be described below. FIGS. 4(a) to 4(c) show one example of the configuration of the light guide 12 serving as the light transmission path, where FIG. 4(a) is a side view, FIG. 4(b) is a cross-sectional view, and FIG. 4(c) is a perspective view. FIG. 4(b) is a cross-sectional view taken along line AA' of FIG. 4(a).

As shown in FIGS. 4(a) to 4(c), the light guide 12 is configured to include three column-shaped cores 13 centering on the light transmitting direction, and a clad 14 arranged to surround the periphery of the cores 13. The core 13 and the clad 14 are made of a material having translucency, and the index of refraction of the core 13 is higher than the index of refraction of the clad 14. The optical signal that entered each core 13 is transmitted in the light transmitting direction by repeating total reflection inside the core 13.

As shown in FIGS. 4(a) to 4(c), the portion opposing the structural body in the lubricating layer 10 is a flat surface (planar surface) 10a. In the following, the light transmitting direction is the x direction, the normal direction of the planar surface 10a is the y direction, and the direction perpendicular to the light transmitting direction and the normal direction is the z direction.

The material constituting the core 13 and the clad 14 may be glass or plastic, but a flexible material having a bending elasticity of smaller than or equal to 1000 MPa is preferable to constituting the light guide 12 having sufficient flexibility. The material constituting the light guide 12 is preferably resin containing a hydrogen bonding group in the functional group of the precursor. The material constituting the light guide 12 may be an acryl, epoxy, urethane, and silicone resins. The clad 14 may be constituted by has such as air. Furthermore, similar effects can be obtained even if the clad 14 is used under an atmosphere of liquid having smaller index of refraction than the core 13.

In the configuration shown in FIGS. 4(a) to 4(c), the cross-sectional shape of the core 13 is rectangular at the plane perpendicular to the light transmitting direction. However, the cross-sectional shape of the core 13 is not limited to a rectangle, and may be a circle.

The light guide 12 may be a single core structure in which one core 13 is arranged, or a multi-core structure in which a plurality of cores 13 is arranged. In the case of the single-core structure, one-way transmission may be implemented, or two-way transmission may be implemented. In the case of the multi-core structure, one-way transmission of performing signal transmission in the same direction in all cores may be implemented, or two-way transmission may be implemented by changing the signal transmitting direction at each core.

In the manufacturing procedure of the optical wiring 4 shown in FIGS. 4(a) to 4(c), the lubricating layer 10 is molded on the light transmission path 9 (side opposite to the fabricating substrate) or the lubricating layer 10 molded in advance is attached after molding the light transmission path 9 on the fabricating substrate to the desired shape. The fabricating substrate is separated from the light transmission path 9 to complete the optical wiring 4 of the present embodiment.

For the fabricating method of the light transmission path 9, the direct exposure method, direct drawing method, RIE method, spin coating method, photo-bleaching method, duplicating method, die injection molding method, fiber spinning molding method, and the like are preferable. For the fabricating method of the lubricating layer 10, a general fabricating method of the light guide such as the direct exposure method, direct drawing method, RIE method, spin coating method, and duplicating method, or a thin-film fabricating method such as vapor deposition method and spray coating method can be adopted when molding the lubricating layer 10 on the light transmission path 9. When attaching the lubricating layer 10 molded in advance, a film fabricating method such as die injection molding method, drawing method, inflation method, T-die method, and calendar method can be adopted.

As another manufacturing procedure of the optical wiring 4, a procedure of molding the light transmission path 9 on the lubricating layer 10 to a desired shape or attaching the light transmission path 9 molded in advance after fabricating the lubricating layer 10 may be adopted.

In the case of such manufacturing procedure, the method of fabricating the lubricating layer 10 may be a film fabricating method such as die injection molding method, drawing method, inflation method, T-die method, and calendar method can be adopted. The fabricating method of the light transmission path 9 is, in particular, preferably the direct exposure method, direct drawing method, RIE method, spin coating method, photo-bleaching method, duplicating method, die injection molding method, fiber spinning molding method, and the like. Such methods are methods enabling the light transmission path 9 to be fabricated on the lubricating layer 10.

As another further manufacturing procedure of the optical wiring 4, a procedure of molding the lubricating layer 10 with the light transmission path 9 as a substrate or attaching the lubricating layer 10 molded in advance after molding the light transmission path 9 to a desired shape may be adopted.

Generally, the optical wiring mounted on the electronic device such as a mobile device is demanded to have light transmission performance, bending/twisting performance, anti-abrasion/contact performance (contact with the structural body in the electronic device) from the standpoint of reducing space. The light transmission performance is the performance for transmitting optical signals, and is the performance necessary for high-speed optical signal transmission. The bending/twisting performance is the bending, twisting, repeated bending, and repeated twisting characteristics of the optical wiring, and is the performance necessary for mounting the optical wiring in a small space (reduce space). The anti-abrasion/contact performance is the performance indicating the difficulty in deforming by contact (difficulty in breaking), difficulty in being subjected to friction with the structural body (difficultly in scraping), and difficulty in being abraded, and is the performance necessary to prevent influence on the contact with the structural body in a small space.

In the conventional light transmission path, the selection of the material satisfying three performances, the light transmission performance, the bending/twisting performance, and the anti-abrasion/contact performance was difficult. In other words, even if a material that enhances the light transmission performance and the bending/twisting performance is selected for the material of the light transmission path, such material did not necessarily enhance the anti-abrasion/contact performance. In other words, it was difficult to satisfy the bending/twisting performance and the anti-abrasion/contact performance with one material in the selection of the material of the light transmission path.

The optical wiring 4 of the present embodiment may be considered to have a configuration in which the lubricating layer 10 is separately arranged as a member responsible for the anti-abrasion/contact performance. The lubricating layer 10 is responsible for the anti-abrasion/contact resistance of the light transmission performance, the bending/twisting performance, and the anti-abrasion/contact performance, and thus the material responsible for the light transmission performance and the bending/twisting performance has only to be selected when selecting the material of the light transmission path. Thus, the range of selection in the constituting materials increases compared to the prior art in the optical wiring 4 of the present embodiment.

(Variant 1-1)

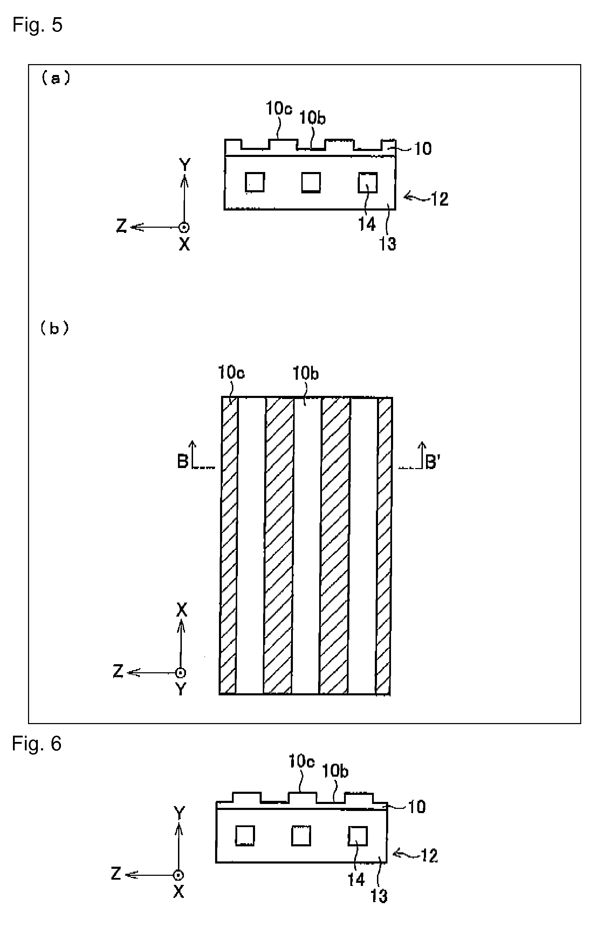

Variant of the configuration shown in FIG. 4 will be described in the configuration of the optical wiring of the present embodiment. FIGS. 5(a) and 5(b) show one example of the configuration of the optical wiring 4 serving as variant 1-1, where FIG. 5(a) is a cross-sectional view and FIG. 5(b) is a plan view. FIG. 5(a) is a cross-sectional view taken along line BB' in FIG. 5(b).

As shown in the figure, the lubricating layer 10 has a concave-convex structure in which the concave portion 10b and the convex portion 10c are alternately formed in the optical wiring 4. The concave-convex structure is formed at the portion facing the structural body in the lubricating layer 10. The concave portion 10b and the convex portion 10c are formed to be parallel to the light transmitting direction of the light guide 12.

The flexibility of the lubricating layer 10 corresponding to the mobility (deformation) of the light guide 12 improves as the concave-convex structure is formed in the lubricating layer 10. As a result, an optical wiring that satisfies the mobility required in the application to the wiring in the electronic device can be realized. In particular, in the configuration in which the concave portion 10b and the convex portion 10c are formed to be parallel to the light transmitting direction of the light guide 12 as in the present variant, the flexibility of the lubricating layer 10 corresponding to the twisting of the light guide 12 improves.

In the optical wiring of variant 1-1, the concave-convex structure is formed at the portion facing the structural body in the lubricating layer 10. Thus, the contacting area of the lubricating layer 10 and the structural body reduces compared to the configuration of FIGS. 4(a) to 4(c) in which the portion facing the structural body in the lubricating layer 10 is flat (planar surface) 10a. The friction of the lubricating layer 10 and the structural body thus can be further reduced.

In the configuration shown in FIGS. 5(a) and 5(b), the convex portion 10c is formed to avoid the core 13 of the light guide 12. However, the convex portion 10c may be formed to overlap the core 13 of the light guide 12, as shown in FIG. 6.

Since the convex portion 10c is formed to overlap the core 13 extending in the light transmitting direction, the stress applied on the clad 14 is less likely to concentrate at the core 13 when the light guide 12 is twisted compared to the configuration in which the convex portion 10c does not overlap the core 13 extending in the light transmitting direction. Furthermore, the leakage light from the core 13 is reflected plural times at the convex portion 10c and easily escapes to the exterior of the light transmission path 9. As a result, the S/N ratio of the signal transmission improves.

(Variant 1-2)

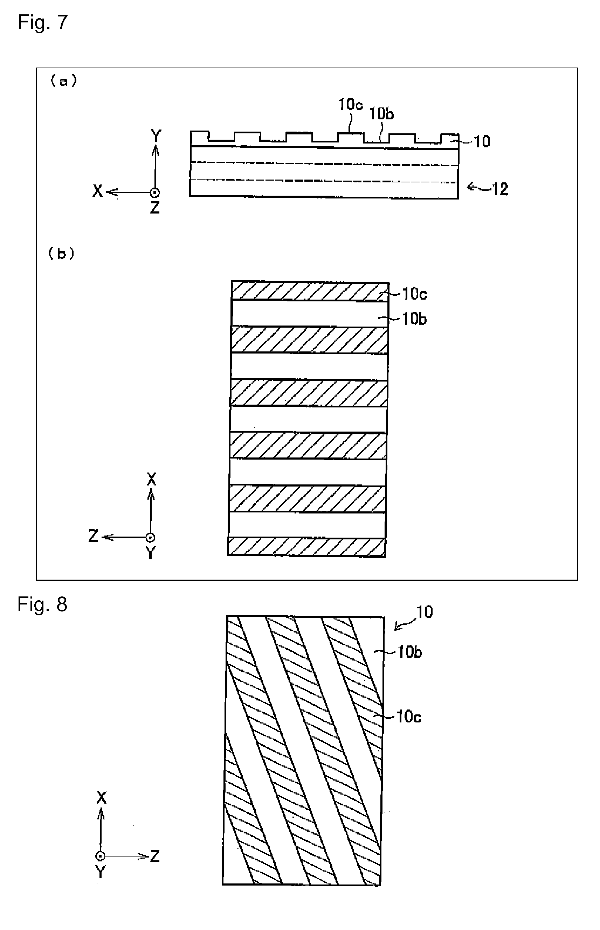

Another variant of the configuration of variant 1-1 will be described in the configuration of the optical wiring of the present embodiment. FIGS. 7(a) and 7(b) show one example of the configuration of the optical wiring 4 serving as variant 1-2, where FIG. 7(a) is a side view and FIG. 7(b) is a plan view.

In the configuration of variant 1-1, the concave portion 10b and the convex portion 10c are formed to be parallel to the light transmitting direction of the light guide 12. In the optical wiring 4 serving as variant 1-2, on the contrary, the concave portion 10b and the convex portion 10c are formed to be parallel to the light transmitting direction of the light guide 12. The flexibility of the lubricating layer 10 corresponding to the bending of the light guide 12 thus improves.

(Variant 1-3)

Still another variant of the configuration of the above variants will be described in the configuration of the optical wiring of the present embodiment. FIG. 8 is a plan view showing one example of the configuration of the optical wiring 4 serving as variant 1-3.

In the configuration of the above variant, the concave portion 10b and the convex portion 10c are formed to be parallel to or perpendicular to the light transmitting direction of the light guide 12. In the optical wiring 4 serving as variant 1-3, on the contrary, the concave portion 10b and the convex portion 10c are formed to incline with respect to the light transmitting direction of the light guide 12. The flexibility of the lubricating layer 10 corresponding to the bending of the light guide 12 thus particularly improves.

(Variant 1-4)

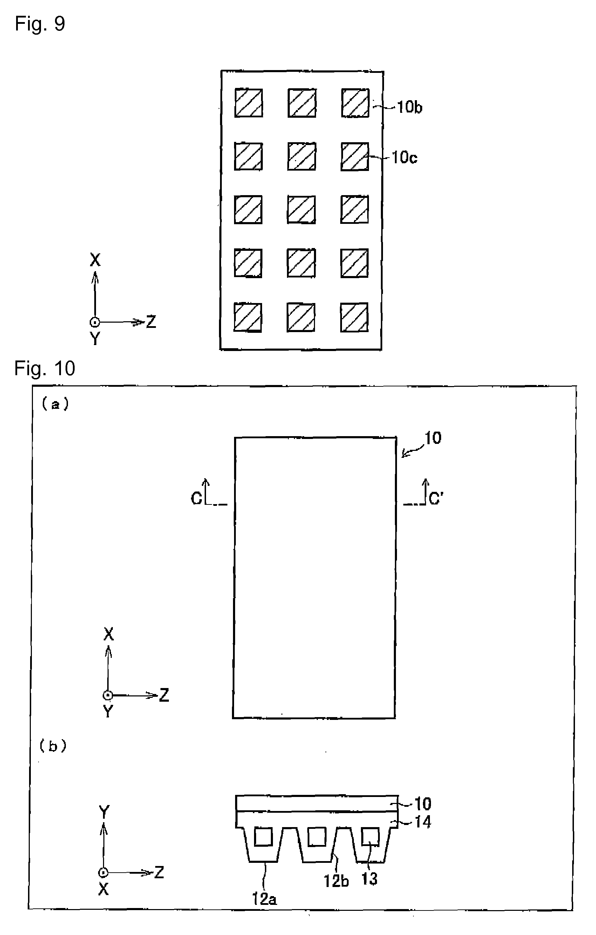

Still another variant of the configuration of the above variants will be described in the configuration of the optical wiring of the present embodiment. FIG. 9 is a plan view showing one example of a configuration of the optical wiring 4 serving as variant 1-4.

In the optical wiring 4 serving as variant 1-3, the concave portion 10b is formed to be parallel to and perpendicular to the light transmitting direction of the light guide 12. The concave portion 10b and the convex portion 10c form a lattice shape. The flexibility of the lubricating layer 10 corresponding to the twisting and the bending of the light guide 12 thus improves.

In the manufacturing procedure of the optical wirings of variants 1-1 to 1-4, the light guide 12 is fabricated on a cured object of the material constituting the lubricating layer 10 or the light guide 12 fabricated in a different step is attached after filling and curing the material constituting the lubricating layer 10 in the die having the concave-convex structure. The die is then separated to complete the optical wirings of variants 1-1 to 1-4. The light guide fabricated in a different step may be a light guide molded on the fabricating substrate. In this case, the fabricating substrate and the die are separated after attaching the light guide molded on the fabricating substrate on the cured object of the material constituting the lubricating layer 10 to complete the optical wirings of variants 1-1 to 1-4.

As another manufacturing procedure, a procedure of cutting the lubricating layer 10 to a concave-convex shape after fabricating the optical wiring through the manufacturing procedure of the optical wiring 4 shown in FIGS. 4(a) to 4(c).

As still another manufacturing procedure, a photosensitive resin is first applied to the light guide 12 fabricated in advance as a material of the lubricating layer 10. After the photosensitive resin is exposed to form the concave-convex structure therein, development is carried out to complete the optical wirings of variants 1-1 to 1-4.

As still another manufacturing procedure, a thermoplastic resin is applied to the light guide 12 fabricated in advance as a material of the lubricating layer 10. Thereafter, a die having the concave-convex structure is pressed against the thermoplastic resin, and thermal transfer is carried out. The die having the concave-convex structure is then stripped to complete the optical wirings of variants 1-1 to 1-4.

As still another manufacturing procedure, a thermosetting resin or a photosensitive resin is applied on the light guide12 fabricated in advance as a material of the lubricating layer 10. Thereafter, a die having the concave-convex structure is pressed against and transferred to the thermosetting resin or the photosensitive resin, and heat hardening is carried out. The die having the concave-convex structure is then stripped to complete the optical wirings of variants 1-1 to 1-4.

As still another manufacturing procedure, the concave-convex structure is formed after applying the material of the lubricating layer 10 on a dummy substrate. Thereafter, a holding substrate is molded to hold the concave-convex structure of the lubricating layer 10. In this case, the concave-convex structure of the holding substrate obtained by molding and the concave-convex structure of the lubricating layer 10 are in a fit-in relationship. In other words, the holding substrate holds the lubricating layer 10 from the concave-convex structure side. After stripping the dummy substrate, the light guide 12 is fabricated on the surface on the side opposite to the holding substrate of the lubricating layer 10 or the light guide 12 fabricated in another step is attached. The die is then separated to complete the optical wirings of variants 1-1 to 1-4. The holding substrate is then stripped to complete the optical wirings of variants 1-1 to 1-4.

As still another manufacturing procedure, a procedure of preparing the lubricating layer 10 formed with the concave-convex structure through the film fabricating method such as the die injection molding method, the drawing method, the inflation method, the T die method, and the calendar method, and fabricating the light guide 12 in the lubricating layer 10 or attaching the light guide 12 fabricated in a different step.

(Variant 1-5)

Still another further variant of the above variants will be described in the configuration of the optical wiring of the present embodiment. FIGS. 10(a) and 10(b) show one example of the configuration of the optical wiring 4 serving as variant 1-5, where FIG. 10(a) is a plan view and FIG. 10(b) is a cross-sectional view taken along line CC'.

In the above variants, the concave-convex structure is formed at the portion facing the structural body in the lubricating layer 10. In the optical wiring 4 of variant 1-5, on the other hand, the concave-convex structure is formed at the portion on the side opposite to the lubricating layer 10 in the light guide 12.

As shown in FIGS. 10(a) and 10(b), the light guide 12 includes the core 13 and the clad 14 for surrounding the core 13. The portion on the side opposite to the lubricating layer 10 of the light guide 12 has a concave-convex structure in which a concave portion 12a and a convex portion 12b are alternately formed. The side wall forming the concave portion 12a is made of a material constituting the clad 14. In other words, the concave portion 12a is made of only the material constituting the clad 14. The convex portion 12b is made of a material constituting the clad 14 and a material constituting the core 13 (i.e., the convex portion 12b contains material constituting the core 14), and the clad 14 surrounds the core 13. In other words, the light guide 12 in the optical wiring 4 of variant 1-5 has a configuration in which the concave portion 12a is formed to avoid the core 13 at the portion on the side opposite to the lubricating layer 10.

In such configuration as well, the mobility of the light guide 12 itself improves. As a result, the optical wiring satisfying the mobility required in the application to the wiring in the electronic device can be realized.

In the configurations shown in variants 1-1 to 1-5, the lubricating layer 10 reduces the friction that occurs at the time of coming in contact with the structural body in the electronic device than at the time that the light guide 12 comes in contact with the structural body, and also has a concave-convex structure on the surface. Thus, when the configurations shown in variants 1-1 to 1-5 are adopted, the optical wiring 4 has the following effects in addition to the effects in that the contacting area with the structural body reduces, and the slidability with the structural body generates so that the bendability of the light guide 12 is not inhibited.

In other words, since the leakage light from the core 13 that occurs at the time of bending the light guide 12 escapes to the air at the exterior of the clad 14, the occurrence of noise can be suppressed and the lowering of the S/N ratio can be prevented.

Furthermore, as the concave-convex structure is configured so that the stress in the lubricating layer 10 weakens in accordance with the bending and the twisting direction of the light guide 12, so that the flexibility (flexible property) of the lubricating layer 10 greatly improves compared to the configuration in which the flat layer serving as the lubricating layer 10 is arranged as shown in FIG. 4.

(Variant 2)

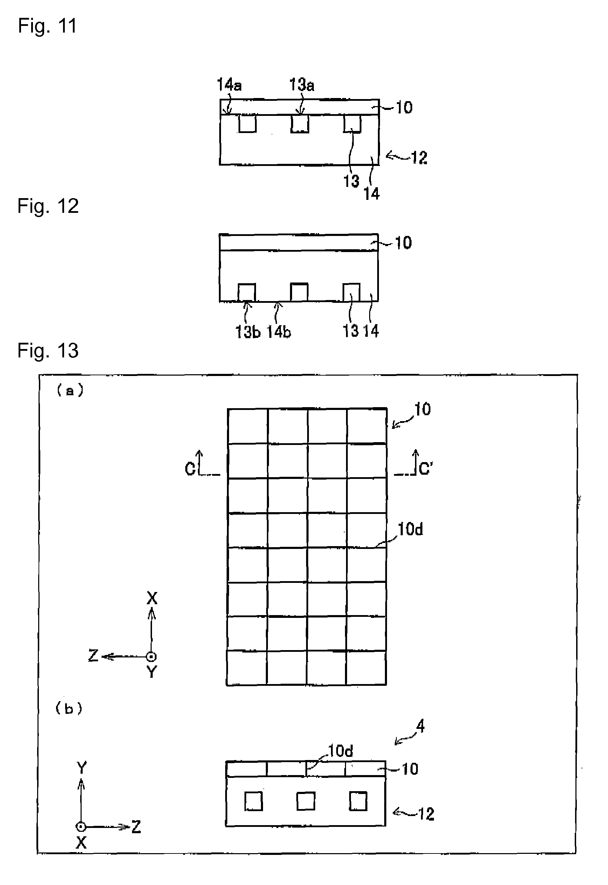

Still another further variant of the configuration shown in FIG. 4 will be described in the configuration of the optical wiring of the present embodiment. FIG. 11 is a cross-sectional view showing one example of the configuration of the optical wiring 4 serving as variant 2.

In the configuration shown in FIGS. 4(a) to 4(c), the light guide 12 is configured to include three column-shaped cores 13 centering on the light transmitting direction, and the clad 14 arranged to surround the periphery of the cores 13. The core 13 does not directly come in contact with the lubricating layer 10, and the clad 14 comes in contact with the lubricating layer 10.

The optical wiring 4 of variant 2, on the other hand, has a configuration in which the core 13 directly comes in contact with the lubricating layer 10. The surface on the light guide 12 side in the lubricating layer 10 is a flat surface (planar surface). The contacting surface 13a with the lubricating layer 10 of the core 13 is in the same plane as the contacting surface 14a with the lubricating layer 10 of the clad 14.

The optical wiring 4 of variant 2-1 has a configuration in which the clad 14 formed on the lubricating layer 10 side with respect to the core 13 is omitted. Thus, the thickness in the y-direction (normal direction) can be thinned compared to the optical wiring 4 shown in FIGS. 4(a) to 4(c).

In order to reduce the thickness in the y-direction, the optical wiring 4 has a configuration in which the surfaces 13b, 14b on the side opposite to the lubricating layer 10 of the core 13 and the clad 14 are in the same plane, as shown in FIG. 12.

(Variant 3)

Still another variant of the configuration showing in FIG. 4 will be described in the configuration of the optical wiring of the present embodiment. FIGS. 13(a) and 13(b) show one example of the configuration of the optical wiring 4 serving as variant 3, where FIG. 13(a) is a plan view and FIG. 13(b) is a cross-sectional view taken along line CC'.

In the configuration shown in FIGS. 4(a) to 4(c), the portion facing the structural body in the lubricating layer 10 is a flat surface (planar surface) 10a. In the optical wiring 4 of variant 3, on the other hand, a lattice-shaped slid 10d is formed in the lubricating layer 10. In such configuration as well, the flexibility of the lubricating layer 10 corresponding to the twisting and the bending of the light guide 12 improves.

(Variant 4)

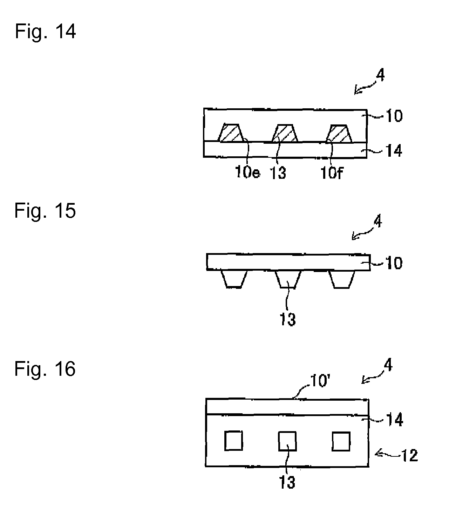

Still another variant of the configuration showing in FIG. 4 will be described in the configuration of the optical wiring of the present embodiment. FIG. 14 is a cross-sectional view showing one example of the configuration of the optical wiring 4 serving as variant 4.

In the configuration shown in FIGS. 4(a) to 4(c), the contacting surface with the light guide 12 in the lubricating layer 10 is a flat surface (planar surface). The optical wiring 4 of variant 4, on the other hand, has the portion on the light guide 12 side in the lubricating layer 10 formed to a concave-convex structure in which the concave portion 10e and the convex portion 10f are alternately formed. The core 13 is formed to fit in the concave portion 10e.

The optical wiring 4 of variant 4 has a configuration in which the clad 14 formed on the lubricating layer 10 side with respect to the core 13 is omitted. Thus, the thickness in the y-direction (normal direction) can be reduced compared to the optical wiring 4 shown in FIGS. 4(a) to 4(c).

(Variant 5)

Still another variant of the configuration showing in FIG. 4 will be described in the configuration of the optical wiring of the present embodiment. FIG. 15 is a cross-sectional view showing one example of the configuration of the optical wiring 4 serving as variant 5.

In the configuration shown in FIGS. 4(a) to 4(c), the light guide is configured to include three column-shaped cores 13 centering on the light transmitting direction, and the clad 14 arranged to surround the periphery of the cores 13. The optical wiring 4 of variant 5, on the other hand, has the light transmission path configured only by the three column-shaped cores 13. In other words, the optical wiring 4 of variant 5 has a configuration in which the three column-shaped cores are arranged in only one lubricating layer 10.

(Variant 6)

Still another further variant of the configuration showing in FIG. 4 will be described in the configuration of the optical wiring of the present embodiment. FIG. 16 is a cross-sectional view showing one example of the configuration of the optical wiring 4 serving as variant 6.

In the configuration shown in FIGS. 4(a) to 4(c), the material constituting the lubricating layer 10 is an organic material or a metal material. In the optical wiring 4 of variant 6, on the other hand, the lubricating layer is a primer layer 10' made of a primer material that caps the non-reactive group of the constituting material (i.e., material constituting the clad 14) existing on the surface of the light guide 12.

Since the light guide 12 is made of a resin material as described above, the surface has tack property (adhesive property). The light guide 12 causes breakage, scraping, and abrasion when coming in contact with the structural body in the electronic device due to such tack property. Furthermore, the tack property arises from the non-reactive group remaining on the surface of the light guide 12.

In the optical wiring 4 of variant 6, the primer layer 10' caps the non-reactive group existing on the surface of the light guide 12. Thus, the tack property of the surface of the light guide 12 lowers, and the friction that occurs when coming in contact with the structural body in the electronic device can be reduced.

The primer layer 10' may be formed on the surface facing the structural body in the light guide 12 or may be formed on the surface on the side opposite to the structural body in the light guide 12. Furthermore, the primer layer 10' may be formed on both the opposing surface and the surface on the opposite side.

The primer material constituting the primer layer 10' is not particularly limited as long it is a material that reacts with the non-reactive group on the surface of the light guide 12, which is the source of the tack property, and may be a silane coupling agent, a fluorine coupling agent, or fluoride.

The manufacturing procedure of the optical wiring 4 of variant 6 includes spin coating or spray coating the primer solution, in which the primer material is dissolved in the solvent, on the light guide 12 fabricated in advance. The primer solution is thereafter dried to complete the optical wiring 4 of variant 6.

Another manufacturing procedure includes first applying the primer solution on the substrate, and then placing the substrate on the light guide 12 fabricated in advance. Here, the substrate is placed so that the surface applied with the primer solution faces the light guide 12 to thereby transfer the primer solution to the light guide 12. The primer solution is thereafter dried to complete the optical wiring 4 of variant 6.

Still another manufacturing procedure includes placing the primer solution in a container formed with microscopic holes at the bottom, and placing the primer solution that leaked out from the microscopic holes on the light guide 12 fabricated in advance. The primer solution is thereafter dried to complete the optical wiring 4 of variant 6.

Still another manufacturing procedure includes immersing the light guide 12 fabricated in advance in the primer solution, and then taking out the light guide 12 and drying the same.

(Variant 7)

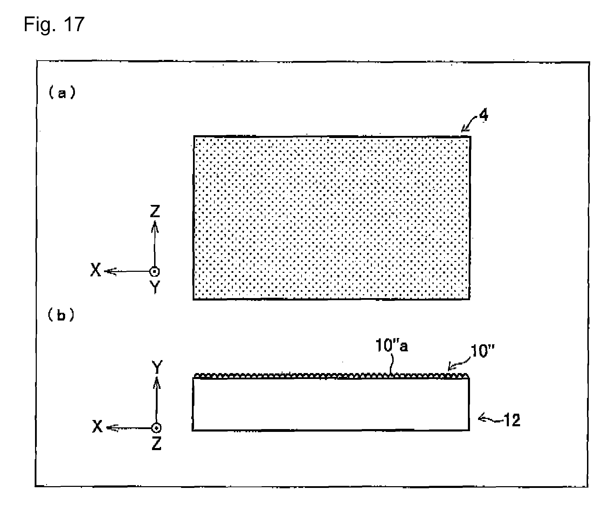

Still another variant of the configuration showing in FIG. 4 will be described in the configuration of the optical wiring of the present embodiment. FIGS. 17(a) and 17(b) show one example of the configuration of the optical wiring 4 serving as variant 7, where FIG. 17(a) is a plan view and FIG. 17(b) is a cross-sectional view.

In the configuration shown in FIGS. 4(a) to 4(c), the material constituting the lubricating layer 10 is an organic material or a metal material. In the optical wiring 4 of variant 7, on the other hand, the lubricating layer is a coating layer 10" made of a solidified object consisting of a mixture of a coating material and a volatile solvent.

For the manufacturing procedure of the optical wiring 4 of variant 7, the coating solution in which the coating material is dissolved in a volatile solvent is spin coated, spray coating screen printed, flexographic printed, or bar coated on the light guide 12 fabricated in advance. Thereafter, the mixture is dried to complete the optical wiring 4 of variant 7.

When the mixture of the coating material and the volatile solvent is dried, the volatile solvent in the mixture volatilizes, and a plurality of aggregated objects 10"a of the coating material are formed on the surface of the light guide 12. In the optical wiring 4 of variant 7, the plurality of aggregated objects 10"a become the convex portion, thereby forming the concave-convex structure. Thus, the contacting area of the coating layer 10" and the structural body can be reduced. The friction between the coating layer 10" and the structural body can also be reduced.

In the concave-convex structure of the coating layer 10", the plurality of aggregated objects 10"a form the convex portion, and the concave portion is formed by the volatilization of the volatile solvent. That is, the bottom surface of the concave portion is substantially the same as the surface of the light guide 12. Thus, in variant 7, the thickness of the optical wiring 4 can be reduced, and the slidability of the optical wiring 4 with respect to the structural body can be enhanced without inhibiting the bendability of the light guide 12.

The coating material contained in the material constituting the coating layer 10" includes an amino silane coupling agent. In particular, the sliding effect of the coating material improves by mixing the fluorine coating material to the amino silane coupling agent. The volatile solvent is not particularly limited as long as it is volatile. For instance, IPA (isopropyl alcohol) may be listed.

In variant 7, the concave-convex structure of the coating layer 10" becomes significant (high and low difference in the concave-convex structure becomes larger) the higher the water repelling property of the material constituting the surface of the light guider 12 (e.g., material constituting the clad). The high and low difference in the concave-convex structure of the coating layer 10" becomes smaller the higher the hydrophilic property of the material constituting the surface of the light guide 12. Thus, the coating layer 10" itself may serve as the clad by using the target of coating the mixture of the coating material and the volatile solvent as the core made of the hydrophilic material. In this case, the concave-convex structure having the high and low difference corresponding to the hydrophilic property of the core is formed in the coating layer 10" serving as the clad.

(Variant 8)

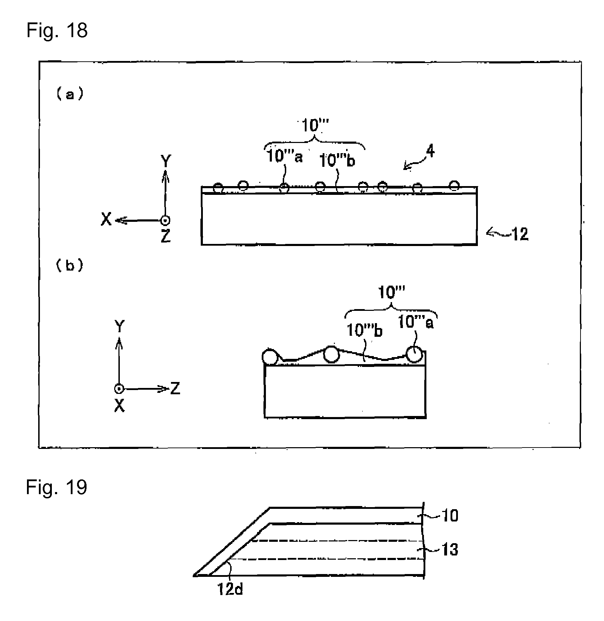

Still another variant of the configuration showing in FIG. 4 will be described in the configuration of the optical wiring of the present embodiment. FIGS. 18(a) and 18(b) show one example of the configuration of the optical wiring 4 serving as variant 8, where FIG. 18(a) is a cross-sectional view and FIG. 18(b) is a cross-sectional view in which one part of the optical wiring 4 is enlarged.

As shown in FIGS. 18(a) and 18(b), the lubricating layer in the optical wiring 4 of variant 8 is a composite layer 10'" including a fine particles 10'"a having slidability and a fixed layer including a solidified object of a soft resin 10'"b for fixing the fine particles 10'"a, where the fine particles 10'"a project out with respect to the fixed layer. In the composite layer 10'", the concave-convex structure is formed by the fine particles 10'"a projecting out with respect to the fixed layer.

For the manufacturing procedure of the optical wiring 4 of variant 8, a resin solution in which the soft resin 10'"b is dissolved in the solvent is prepared, and the fine particle mixed solution in which the fine particles 10'"a is mixed in the resin solution is prepared. The fine particle mixed solution is then spin coated, spray coated, or bar coated on the light guide 12 fabricated in advance. Thereafter, the fine particle mixed solution is dried to complete the optical wiring 4 of variant 8.

When the fine particle mixed solution is dried, the soft resin 10'"b in the fine particle mixed solution is solidified to become the fixed layer with the evaporation of the solvent, and the fine particles 10'"a project out with respect to the fixed layer. As shown in FIG. 18(b), the concave portion is formed by the solidified object of the soft resin 10'"b between the fine particles 10'"a. The solidified object of the soft resin 10'"b is formed through methods such as spin coating, spray coating, or bar coating, and thus the film thickness of the concave portion can be thinned, and the bendability of the light guide 12 is not inhibited. In the composite layer 10'", the concave-convex structure is formed by the fine particles 10'"a projecting out with respect to the fixed layer and the concave portion.

In the optical wiring 4 of the variant 8, the composite layer 10'" includes the fine particles 10'"a serving as the convex portion with a spherical surface, and thus the contacting area with the structural body can be reduced. The friction between the composite layer 10'" and the structural body thus can be reduced, and the slidability with respect to the structural body can be enhanced.

The effect of reducing the friction with respect to the structural body becomes higher the larger the particle diameter of the fine particles 10'"a. The present inventors have found that the effect of reducing the friction with respect to the structural body becomes higher the larger the particle diameter of the fine particles 10'"a but cracks form in the solidified object of the soft resin 10'"b serving as the concave portion between the fine particles 10'"a when the particle diameter is grater than or equal to 450 nm, as a result of reviewing the friction with respect to the structural body while changing the particle diameter of the fine particles 10'"a. The particle diameter of the fine particles 10'"a is preferably less than 450 nm.

The material of the fine particles 10'"a is not particularly limited as long as it is a material having slidability with respect to the structural body, and may be wet silica, dry silica, alumina, copper (Cu), silver (Ag), or gold (Au). The metal nano particles consisting of copper (Cu), silver (Ag), or gold (Au) may be used for the fine particles 10'"a.

The soft resin 10'"B may be a water-soluble urethane resin, silicone, a fluorine resin, a silane coupling agent, or an epoxy resin.

The composite layer 10'" itself may serve as the clad by using the target of coating the fine particle mixed solution as the core.

(Variant 9)

Still another variant of the configuration showing in FIG. 4 will be described in the configuration of the optical wiring of the present embodiment. FIG. 19 is a side view showing one example of the configuration of the optical wiring 4 serving as variant 9.

Variant 7 is a variant in which the lubricating layer 10 is made of a metal material. The end face in the light guide 12 is not perpendicular to the light transmitting direction (x direction), and is cut diagonally to be formed with a light path conversion mirror surface 12d. The optical wiring 4 of variant 9 has a configuration in which the lubricating layer 10 made of a metal material is arranged on the light path conversion mirror surface 12d of the light guide 12.

Since the lubricating layer 10 is made of a metal material, the lubricating layer arranged at the light path conversion mirror surface 12c can be used as a metal mirror. Thus, the optical wiring 4 of variant 7 can efficiently convert the light path of the light transmitting the core 13 at the end face.

(Application example)

The optical wiring 4 of the present embodiment can be applied to the following application examples.

First, as a first application example, the optical wiring can be used for the hinge portion of a foldable electronic device such as a foldable portable telephone, a foldable PHS (Personal Handy-phone System), a foldable PDA (Personal Digital Assistant), and a foldable notebook computer.

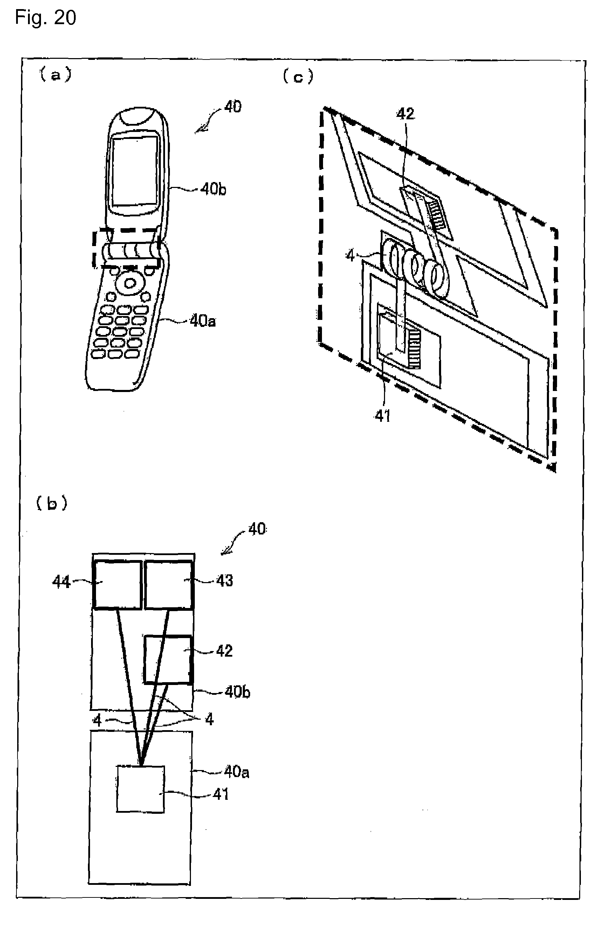

FIGS. 20(a) to 20(c) show an example in which the optical wiring 4 is applied to a foldable portable telephone 40. In other words, FIG. 20(a) is a perspective view showing an outer appearance of the foldable portable telephone 40 incorporating the optical wiring 4.

FIG. 20(b) is a block diagram of a portion where the optical wiring 4 is applied in the foldable portable telephone 40 shown in FIG. 20(a). As shown in the figure, a control unit 41 arranged on a body 40a side in the foldable portable telephone 40, an external memory 42, a camera (digital camera) 43, and a display unit (liquid crystal display) 44 arranged on a lid (drive portion) 40b side rotatably arranged at one end of the body with the hinge portion as a shaft are connected by the optical wiring 4.

FIG. 20(c) is a perspective plan view of the hinge portion (portion surrounded with a broken line) in FIG. 20(a). As shown in the figure, the optical wiring 4 is wound around a supporting rod at the hinge portion and bent to thereby connect the control unit arranged on the body side, and the external memory 42, the camera 43 and the display unit 44 arranged on the lid side.

High speed and large capacity communication can be realized in a limited space by applying the optical wiring 4 to the foldable electronic device. Therefore, the optical wiring 4 is particularly suited for devices where high speed and large capacity data communication is necessary and miniaturization is demanded such as the foldable liquid crystal display.

As a second application example, the optical wiring 4 is applied to a device having a drive portion such as a printer head in a printing device (electronic device) and a reading unit in a hard disc recording and reproducing device.

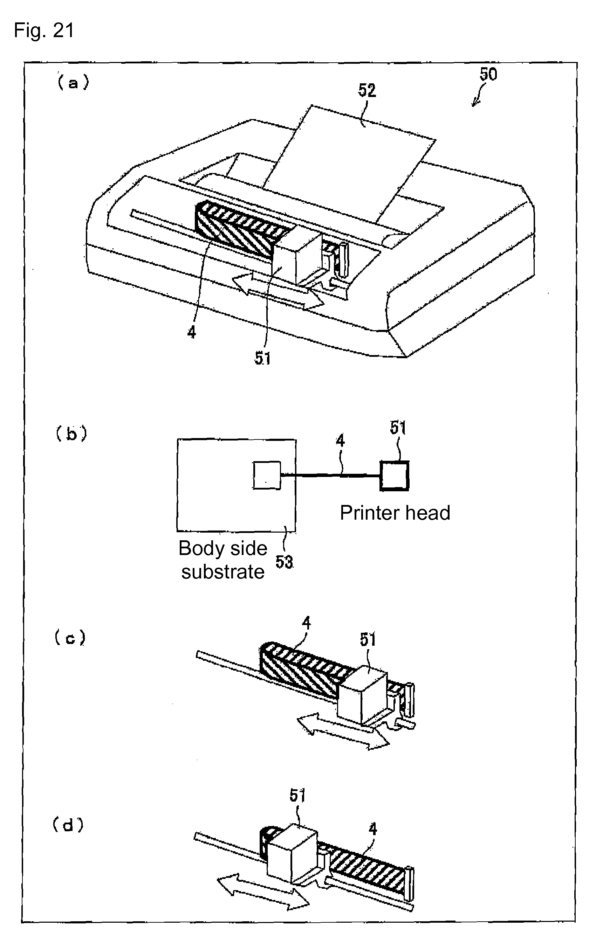

FIGS. 21(a) to 21(c) show an example in which the optical wiring 4 is applied to a printing device 50. FIG. 21 (a) is a perspective view showing an outer appearance of the printing device 50. The printing device 50 includes a printer head 51 for performing printing on a paper 52 while moving in a width direction of a paper 52, where one end of the optical wiring 4 is connected to the printer head 51.

FIG. 21(b) is a block diagram of a portion where the optical wiring 4 is applied in the printing device 50. As shown in the figure, one end of the optical wiring 4 is connected to the printer head 51, and the other end is connected to a body side substrate in the printing device 50. The body side substrate includes a control means for controlling the operation of each unit of the printing device 50, and the like.

FIG. 21(c) and 21(d) are perspective views showing a curved state of the optical wiring 4 when the printer head 51 is moved (driven) in the printing device 50. As shown in the figure, when the optical wiring 4 is applied to the drive portion such as the printer head 51, the curved state of the optical wiring 4 changes by the drive of the printer head 51 and each position of the optical wiring 4 repeatedly curves.

Therefore, the optical wiring 4 according to the present embodiment is suited for such drive portion. High speed and large capacity communication using the drive portion can be realized by applying the optical wiring 4 to such drive portions.

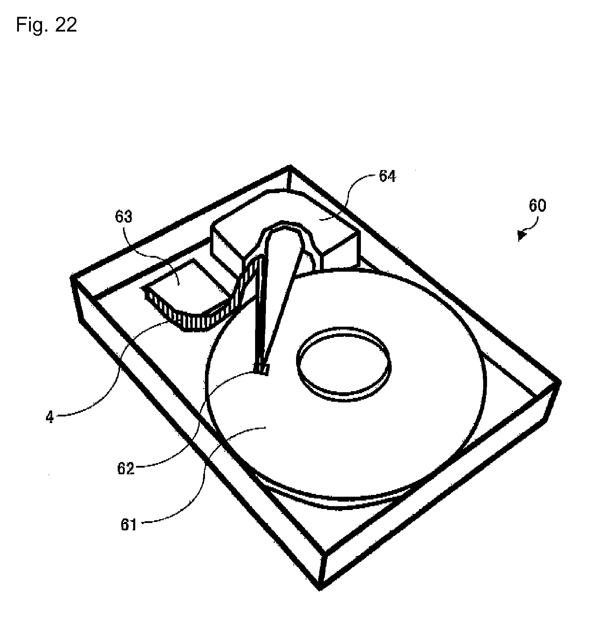

FIG. 22 shows an example in which the optical wiring 4 is applied to a hard disc recording and reproducing device 60.

As shown in the figure, the hard disc recording and reproducing device 60 includes a disc (hard disc) 61, a head (read/write head) 62, a substrate introducing portion 63, a drive portion (drive motor) 64, and the optical wiring 4.

The drive portion 64 drives the head 62 along a radial direction of the disc 61. The head 62 reads the information recorded on the disc 61 and writes the information on the disc 61. The head 62 is connected to the substrate introducing portion 63 by way of the optical wiring 4, and propagates the information read from the disc 61 to the substrate introducing portion 63 as an optical signal and receives the optical signal of the information to be written to the disc 61, propagated from the substrate introducing portion 63.

Therefore, high speed and large capacity communication can be realized by applying the optical wiring 4 to the drive portion such as the head 62 in the hard disc recording and reproducing device 60.

(Practical use example)

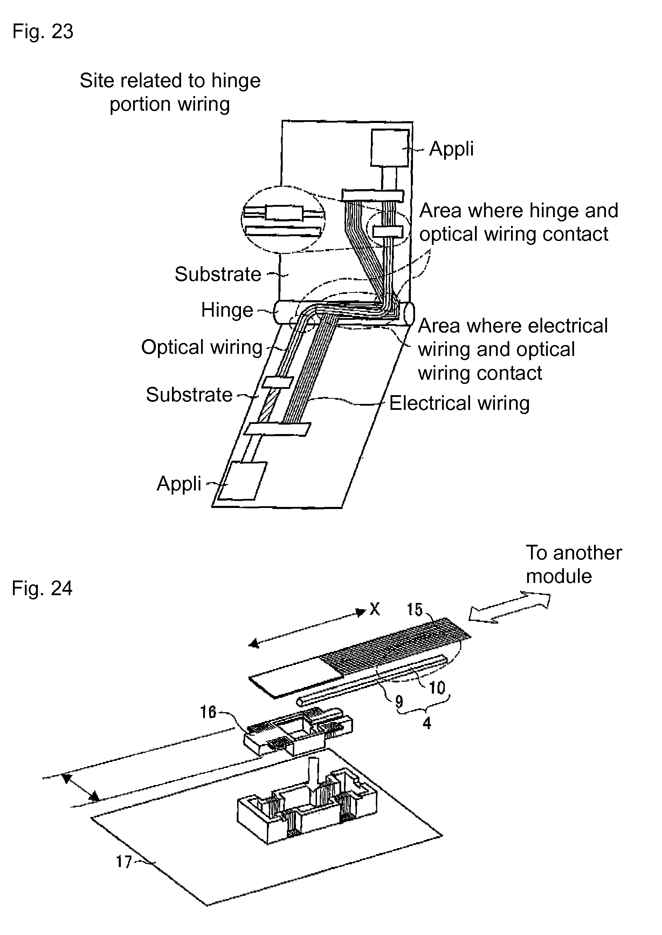

A practical use example of a case where the optical wiring 4 of the present embodiment is applied to the foldable portable telephone 40 serving as the electronic device will now be described. FIG. 23 is a schematic view showing the application area of the optical wiring 4 of the present embodiment in the foldable portable telephone 40.

As shown in FIG. 23, the optical wiring 4 is mounted in a bent state while being wound around a supporting rod at the hinge portion. Thus, the optical wiring 4 of the present embodiment exhibits the effect at the contacting area with the hinge portion serving as the structural body in the electronic device.

In the signal transmission in the foldable portable telephone 40, an electric-light transmission integrated module (hereinafter referred to as integrated module) in which the transmission by the conventional electrical wiring and the transmission by the optical wiring coexist is proposed. The integrated module is a module in which the electrical wiring and the optical wiring can move (deform) as one unit. The transmitting direction of the signal may be a bi-direction, a single direction, or a combination thereof. FIG. 24 is a perspective view showing a schematic configuration of the integrated module.

As shown in FIG. 24, the integrated module includes the optical wiring 4, an electrical wiring 15, a mounting outer unit 16, a substrate 17, and a package 18. The optical wiring 4 and the electrical wiring 15 are arranged to be faced and be parallel to each other. The mounting outer unit 16 is a member for mounting an electrical element for receiving or transmitting the electric signal to transmit in the electrical wiring 15, and an optical element for receiving or transmitting the optical signal to transmit in the optical wiring 4. The mounting outer unit 16 is accommodated in the package 18 arranged on the substrate 17.

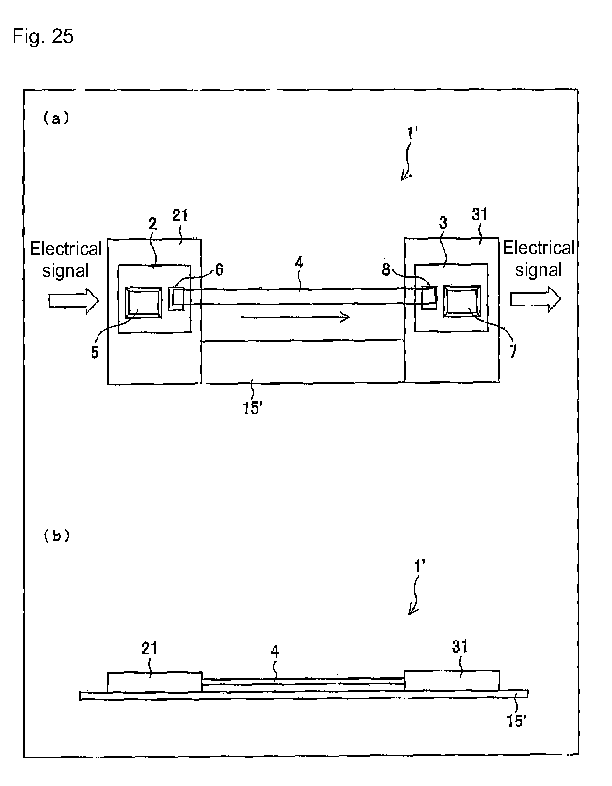

The integrated module may have a configuration shown in FIGS. 25(a) and 25(b). FIG. 25(a) is a functional diagram showing another configuration example of the integrated module.

The integrated module shown in FIG. 25(a) has a configuration in which a flexible print wiring substrate is used as the electrical wiring. As shown in the figure, the integrated module 1' includes a light emission side module unit 21, a light reception side module unit 31, the optical wiring 4, and a flexible print wiring substrate (FPC) 15' serving as the electrical wiring.

The light emission side module unit 21 includes the light transmission processing unit 2 shown in FIG. 2, and is provided to convert the externally input electric signal to a light serving as the optical signal, and to irradiate the light incident side end of the optical wiring 4 with the light. The light reception side module unit 31 includes the light reception processing unit 3 shown in FIG. 2, and is provided to receive the light serving as the optical signal exited from the light exit side end of the optical wiring 4 and to output the electric signal by photoelectric converting the same.

In the integrated module 1', a relatively high speed electric signal of the electric signals input to the light emission side module unit 31 from the outside is converted to the optical signal by the light transmission processing unit 2, and transmitted through the optical wiring 4. The relatively low speed electric signal (e.g., electric signal from the power supply or the ground electrode (GND)) is transmitted through the flexible print wiring substrate 15'. According to such configuration, the integrated module enabling coexistence with the electrical wiring and lower cost can be realized.

FIG. 25(b) is a side view showing one example of the configuration of the integrated module shown in FIG. 25(a). In the integrated module 1' shown in FIG. 25(b), the light emission side module unit 21 and the light reception side module unit 31 are mounted on the flexible print wiring substrate 15'. The optical wiring 4 is arranged to be parallel to the substrate surface of the flexible print wiring substrate 15'.

In the configuration shown in FIG. 25(b), the relatively high speed electric signal transmitted through the flexible print wiring substrate 15' is converted to an optical signal in the light reception side module unit 31, and transmitted to the light emission side module unit 21 through the optical wiring 4.

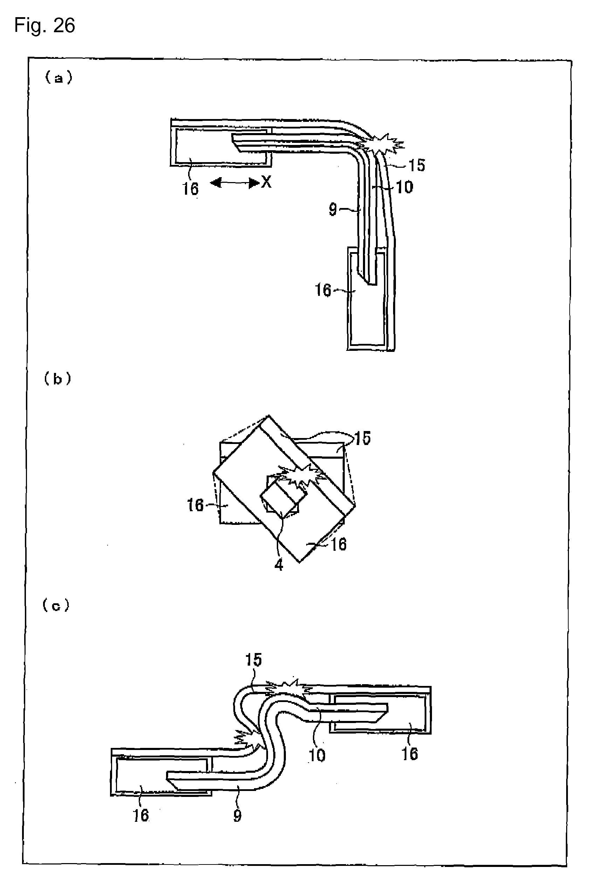

In the above integrated module, the optical wiring 4 of the present embodiment exhibits the effect at the contacting area with the electrical wiring 15. FIGS. 26(a) to 26(c) are views schematically showing a movable (deformation) example of the optical wiring 4 in the integrated module. FIG. 26(a) is a side view showing a movable example of a case where both the optical wiring 4 and the electrical wiring 15 are bent, FIG. 26(b) is a cross-sectional view showing a movable example of the optical wiring 4 when the electrical wiring 15 is twisted, and FIG. 26(c) is a side view showing a movable example of the optical wiring 4 when the electrical wiring 15 slides.

As shown in FIGS. 26(a) to 26(c), the optical wiring 4 comes in contact with the electrical wiring 15 in all the movable examples of the optical wiring 4. The optical wiring 4 of the present embodiment exhibits the effect at such contacting area.

The lubricating layer of a case where the optical wiring 4 of the present embodiment is mounted in the integrated module shown in (a) to (c) of FIG. 24 to FIG. 26 will be described. The lubricating layer has only to have a configuration in which the bendability of the light guide 9 is not inhibited when the light guide 9 and the electrical wiring 15 move (deform) as one unit, and may be the configurations shown in the variants described above.

The lubricating layer may be a substrate used for laminate processing or fabrication of the light guide. The material constituting the lubricating layer is preferably a material that reduces the tack property of the surface of the light guide. The material constituting the lubricating layer may be polyethylene terephthalate (PET), powder, polyimide, a metal material, a primer material, a water vapor processing material, and the like. If the material constituting the lubricating layer is powder, flour, baby powder, and the like may be listed.

The present invention is not limited to the embodiments described above, and various modifications may be made within the scope defined in the Claims. In other words, the embodiments obtained by combining the technical means appropriately modified within the scope of the Claims are also encompassed in the technical scope of the present invention.

The optical wiring according to the present invention includes the light transmission path for transmitting the optical signal, and has a configuration of including a functional layer that reduces the friction that occurs at the time of coming in contact with the structural body in the electronic device than at the time that the light transmission path comes in contact with the structural body, and that bends according to the deformation of the light transmission path.

The light transmission module according to the present invention is a light transmission module including the above-described optical wiring, the light transmission module including a first substrate mounted with a first optical element for converting an electric signal to an optical signal, and a second substrate mounted with a second optical element for converting an optical signal to an electric signal, wherein the optical wiring optically couples with the first and the second optical elements, and transmits the optical signal between the first and the second substrates.

Thus, the mobility required in the application to the wiring in the electronic device is satisfied, and breakage, scarping, and abrasion due to contact with the external structural body can be reduced.

In the optical wiring according to the present invention, the function layer is preferably arranged on a surface including an opposing surface with the structural body in the light transmission path.

The light transmission path is thus reliably prevented from coming in contact with the structural body.

In the optical wiring according to the present invention, at least one of a portion on a side opposite to the function layer in the light transmission path or a portion opposing the structural body in the function layer preferably has a concave-convex structure in which a concave portion and a convex portion are alternately formed.

Thus, the flexibility corresponding to the mobility (deformation) of the light guide improves in the functional layer. As a result, an optical wiring that satisfies the mobility required in the application to the wiring in the electronic device can be realized.

In the optical wiring according to the present invention, the concave portion and the convex portion in the concave-convex structure are preferably formed to be parallel to a light transmitting direction for transmitting the optical signal.

The flexibility corresponding to the twisting of the light transmission path thus improves.

In the optical wiring according to the present invention, the concave portion and the convex portion in the concave-convex structure are preferably formed to be perpendicular to a light transmitting direction for transmitting the optical signal.

The flexibility corresponding to the bending of the light transmission path thus improves.

In the optical wiring according to the present invention, the concave portion and the convex portion in the concave-convex structure are preferably formed to be diagonal to a light transmitting direction for transmitting the optical signal.

The flexibility corresponding to the twisting of the light transmission path thus improves.

In the optical wiring according to the present invention, the concave portion in the concave-convex structure is preferably formed to be parallel to and perpendicular to a light transmitting direction for transmitting the optical signal, and the concave portion and the convex portion preferably form a lattice shape.

The flexibility corresponding to the twisting and the bending of the light transmission path thus improves.

In the optical wiring according to the present invention, a lattice-shaped slit is preferably formed in the function layer.

In the optical wiring according to the present invention, the light transmission path is preferably a light guide including a core made of a material having translucency, and a clad made of a material having an index of refraction different from an index of refraction of the core.

A light transmission path that satisfies the mobility required in the application to the wiring in the electronic device can be realized.

In the optical wiring according to the present invention, the portion opposing the structural body in the function layer preferably has a concave-convex structure including a concave portion and a convex portion, and the convex portion is preferably formed to overlap the core extending in the light transmitting direction. Here, "overlap" means coincidence of the orthogonal projection projected from the structural body side.

According to the above configuration, since the convex portion is formed so as to overlap the core extending in the light transmitting direction, the stress applied on the clad is less likely to concentrate at the core when the light guide is twisted, compared to a configuration in which the convex portion does not overlap the core extending in the light transmitting direction. Furthermore, according to the above configuration, the leakage light from the core is reflected plural times at the convex portion, so as to easily escape to the exterior of the light transmission path. The S/N ratio of the signal transmission thereby improves.

In the optical wiring according to the present invention, the clad is preferably formed to cover a periphery of the core, and a portion on the side opposite to the function layer in the light guide preferably has a concave-convex structure including a concave portion made of only a material constituting the clad and a convex portion including a material constituting the core.

The mobility of the light guide itself thus improves. As a result, an optical wiring that satisfies the mobility required in the application to the wiring in the electronic device can be realized.

In the optical wiring according to the present invention, the portion on the light guide side in the function layer preferably has a concave-convex structure in which a concave portion and a convex portion are alternately formed, and the core is preferably formed to be accommodated in the concave portion.

According to the above configuration, the optical wiring has a configuration in which the clad formed on the functional layer side with respect to the core is omitted. Thus, the thickness can be thinned compared to the optical wiring including the light guide in which the clad is formed to cover the periphery of the core.

In the optical wiring according to the present invention, the core is preferably in contact with the function layer, and a contacting surface with the function layer in the core is preferably in a same plane as a contacting surface with the function layer in the clad.

According to the above configuration, the optical wiring has a configuration in which the clad formed on the functional layer side with respect to the core is omitted. Thus, the thickness can be thinned compared to the optical wiring including the light guide in which the clad is formed to cover the periphery of the core.

In the optical wiring according to the present invention, surfaces on a side opposite to the function layer in the core and the clad are preferably in the same plane.

According to the above configuration, the optical wiring has a configuration in which the clad formed on the side opposite to the functional layer side with respect to the core is omitted. Thus, the thickness can be thinned compared to the optical wiring including the light guide in which the clad is formed to cover the periphery of the core.

In the optical wiring according to the present invention, the light transmission path is preferably constituted only by a core made of a material having translucency.

According to the above configuration, since the clad covering the periphery of the core is omitted, the thickness of the optical wiring can be further thinned.

In the optical wiring according to the present invention, the function layer is preferably made of an organic material having a tensile strength of greater than or equal to 50 MPa, and an elasticity of smaller than or equal to 6500 MPa or smaller than or equal to 80 times the tensile strength, and preferably has a thickness of smaller than or equal to 700 $\mu$m.

If the functional layer is made of an organic material, the functional layer can realize the bendability corresponding to the bending of the light transmission path if the tensile strength is smaller than or equal to 50 MPa, the elasticity is smaller than or equal to 6500 MPa or smaller than or equal to 80 times the tensile strength, and the thickness of the functional layer is smaller than or equal to 700 $\mu$m.

In the optical wiring according to the present invention, the function layer is preferably made of a metal material having a tensile strength of greater than or equal to 100 MPa, and a Young's modulus of smaller than or equal to 200 GPa, and preferably has a thickness of smaller than or equal to 70 $\mu$m.

If the functional layer is made of a metal material, the functional layer can realize the bendability corresponding to the bending of the light transmission path if the tensile strength is smaller than or equal to 100 MPa, the Young's modulus is smaller than or equal to 200 GPa, and the thickness of the functional layer is smaller than or equal to 70 $\mu$m.

In the optical wiring according to the present invention, the function layer is preferably made of a primer material that caps a non-reactive group of a constituting material at the surface of the light transmission path.

The tack property of the surface of the light transmission path thus lowers, and the friction that occurs at the time of coming in contact with the structural body in the electronic device can be reduced.

In the optical wiring according to the present invention, the function layer is preferably made of a solidified object of a mixture of a coating material and a volatile solvent.

In solidifying the mixture of the coating material and the volatile solvent, the volatile solvent in the mixture volatilizes, and a plurality of aggregated objects of the coating material are formed on the surface of the light guide. Thus, the plurality of aggregated objects of the coating material become the convex portions, thereby forming a concave-convex structure. Therefore, the contacting area of the functional layer and the structural body can be reduced. Thus, the friction between the functional layer and the structural body can be further reduced.

In the optical wiring according to the present invention, the function layer preferably includes fine particles, and a fixed layer including a solidified object of a fixing resin for fixing the fine particles, and the fine particles preferably project out with respect to the fixing layer.

According to the above configuration, the fine particle serving as the convex portion projecting out with respect to the fixed layer is a sphere, and thus the contacting area with the structural body can be reduced. Thus, the friction between the functional layer and the structural body can be further reduced, and the slidability with respect to the structural body can be enhanced.

Specific embodiments and examples described in BEST MODE FOR CARRYING OUT THE INVENTION are provided merely to clarify the technical contents of the present invention and should not be interpreted in a narrow sense limiting only to such specific examples, and it should be recognized that embodiments obtained by appropriately combining the technical means disclosed in the different embodiments within the spirit of the invention and the scope of the accompanied Claims are also encompassed in the technical scope of the present invention.

INDUSTRIAL APPLICABILITY

The present invention is also applicable to the optical communication path between various types of devices, and as an in-device wiring mounted in a small and thin commercial-off-the-shelf device.

**Claims**

1. An optical wiring mounted on an electronic device, the optical wiring comprising a light transmission path for transmitting an optical signal,
   wherein a function layer that reduces friction generated when coming in contact with a structural body in the electronic device to lower than when the light transmission path comes in contact with the structural body, and that bends according to deformation of the light transmission path is arranged.

2. The optical wiring according to claim 1, wherein the function layer is arranged on a surface including an opposing surface with the structural body in the light transmission path.

3. The optical wiring according to claim 1 or 2, wherein at least one of a portion on a side opposite to the function layer in the light transmission path or a portion opposing the structural body in the function layer has a concave-convex structure in which a concave portion and a convex portion are alternately formed.

4. The optical wiring according to claim 3, wherein the concave portion and the convex portion in the concave-convex structure are formed to be parallel to a light transmitting direction for transmitting the optical signal.

5. The optical wiring according to claim 3, wherein the concave portion and the convex portion in the concave-convex structure are formed to be perpendicular to a light transmitting direction for transmitting the optical signal.

6. The optical wiring according to claim 3, wherein the concave portion and the convex portion in the concave-convex structure are formed to be diagonal to a light transmitting direction for transmitting the optical signal.

7. The optical wiring according to claim 3, wherein
   the concave portion in the concave-convex structure is formed to be parallel to and perpendicular to a light transmitting direction for transmitting the optical signal; and
   the concave portion and the convex portion form a lattice shape.

8. The optical wiring according to claim 1 or 2, wherein a lattice-shaped slit is formed in the function layer.

9. The optical wiring according to any one of claims 1 to 8, wherein the light transmission path is a light guide including a core made of a material having translucency, and a clad made of a material having an index of refraction different from an index of refraction of the core.

10. The optical wiring according to claim 9, wherein
    the portion opposing the structural body in the function layer has a concave-convex structure including a concave portion and a convex portion; and
    the convex portion is formed to overlap the core extending in the light transmitting direction.

11. The optical wiring according to claim 9, wherein
    the clad is formed to cover a periphery of the core; and
    a portion on the side opposite to the function layer in the light guide has a concave-convex structure including a concave portion made of only a material constituting the clad and a convex portion including a material constituting the core.

12. The optical wiring according to claim 9, wherein

the portion on the light guide side in the function layer has a concave-convex structure in which a concave portion and a convex portion are alternately formed; and

the core is formed to be accommodated in the concave portion.

13. The optical wiring according to claim 9, wherein

the core is in contact with the function layer; and

a contacting surface with the function layer in the core is in a same plane as a contacting surface with the function layer in the clad.

14. The optical wiring according to claim 9, wherein surfaces on a side opposite to the function layer in the core and the clad are in the same plane.

15. The optical wiring according to claim 1 or 2, wherein the light transmission path is constituted only by a core made of a material having translucency.

16. The optical wiring according to any one of claims 1 to 15, wherein the function layer is made of an organic material having a tensile strength of greater than or equal to 50 MPa, and an elasticity of smaller than or equal to 6500 MPa or smaller than or equal to 80 times the tensile strength, and has a thickness of smaller than or equal to 700 $\mu$m.

17. The optical wiring according to any one of claims 1 to 15, wherein the function layer is made of a metal material having a tensile strength of greater than or equal to 100 MPa, and a Young's modulus of smaller than or equal to 200 GPa, and has a thickness of smaller than or equal to 70 $\mu$m.

18. The optical wiring according to any one of claims 1 to 15, wherein the function layer is made of a primer material that caps a non-reactive group of a constituting material at the surface of the light transmission path.

19. The optical wiring according to any one of claims 1 to 15, wherein the function layer is made of a solidified object of a mixture of a coating material and a volatile solvent.

20. The optical wiring according to any one of claims 1 to 15, wherein the function layer includes fine particles, and a fixed layer including a solidified object of a fixing resin for fixing the fine particles; and

the fine particles project out with respect to the fixing layer.

21. A light transmission module including the optical wiring according to any one of claims 1 to 20, the light transmission module comprising:

a first substrate mounted with a first optical element for converting an electric signal to an optical signal; and

a second substrate mounted with a second optical element for converting an optical signal to an electric signal; wherein

the optical wiring optically couples with the first and the second optical elements, and transmits the optical signal between the first and the second substrates.

Fig. 1

Fig. 2

Electric signal →

Electric signal →

Fig. 3

Fig. 4

(a)

A → 10a

10

Y ↑

Z ⊙ → X

A'

12

Light transmitting
direction

(b)

10a

10

Y ↑

X ⊙ → Z

12

13
14

(c)

10a

10

Y ↑

X → Z

12

Light
transmitting
direction

13
14

Fig. 5

(a)

(b)

Fig. 6

Fig. 7

(a)

10c  10b

Y

X

Z

10

12

(b)

10c

10b

X

Z

Y

Fig. 8

10

10b

X

Z

Y

10c

Fig. 9

Fig. 10

Fig. 11

Fig. 12

Fig. 13

Fig. 14

Fig. 15

Fig. 16

Fig. 17

Fig. 18

(a)

10'''
10'''a  10'''b

4

Y
X
Z

12

(b)

10'''
10'''b  10'''a

Y
Z
X

Fig. 19

10
13

12d

Fig. 20

Fig. 21

(a)

(b)

Printer head

Body side
substrate 53

(c)

(d)

Fig. 22

Fig. 23

Site related to hinge
portion wiring

Appli

Area where hinge and
optical wiring contact

Substrate

Hinge

Area where electrical
wiring and optical
wiring contact

Optical wiring

Substrate

Electrical wiring

Appli

Fig. 24

To another
module

Fig. 25

(a)

1'

2 21                    31 3

Electrical
signal                           4                          Electrical
signal

6          8

5                                                          7

15'

(b)

1'

21          4          31

15'

Fig. 26

(a)

16　←→X
9
15
10
16

(b)

15
16
16
4

(c)

15
10
16
16
9

| | | | |
|---|---|---|---|
| **INTERNATIONAL SEARCH REPORT** | | International application No. | |
| | | PCT/JP2008/065888 | |

**A. CLASSIFICATION OF SUBJECT MATTER**
*G02B6/122*(2006.01)i, *G02B6/42*(2006.01)i

According to International Patent Classification (IPC) or to both national classification and IPC

**B. FIELDS SEARCHED**

Minimum documentation searched (classification system followed by classification symbols)
G02B6/12-6/14, G02B6/42

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)
JSTPlus(JDreamII), JST7580(JDreamII)

**C. DOCUMENTS CONSIDERED TO BE RELEVANT**

| Category* | Citation of document, with indication, where appropriate, of the relevant passages | Relevant to claim No. |
|---|---|---|
| Y | JP 2007-233360 A  (Toray Industries, Inc.),<br>13 September, 2007 (13.09.07),<br>Par. Nos. [0024], [0074], [0075], [0099];<br>Fig. 1<br>(Family: none) | 1-21 |
| Y | JP 2007-212899 A  (Omron Corp.),<br>23 August, 2007 (23.08.07),<br>Par. Nos. [0099] to [0113]; Figs. 18 to 20<br>(Family: none) | 1-21 |
| Y | JP 8-153940 A  (Kaneka Corp.),<br>11 June, 1996 (11.06.96),<br>Par. Nos. [0021] to [0033]<br>(Family: none) | 3-8,10-12,<br>16-21 |

| ☒ | Further documents are listed in the continuation of Box C. | ☐ | See patent family annex. |
|---|---|---|---|

| | |
|---|---|
| * Special categories of cited documents:<br>"A" document defining the general state of the art which is not considered    to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| | |
|---|---|
| Date of the actual completion of the international search<br>10 October, 2008 (10.10.08) | Date of mailing of the international search report<br>21 October, 2008 (21.10.08) |
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

| International application No. |
| --- |
| PCT/JP2008/065888 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2006-24584 A   (Sumitomo Electric Printed Circuits, Inc.), 26 January, 2006 (26.01.06), Par. Nos. [0011] to [0030] & KR 10-2006-0048487 A   & CN 1725931 A | 3-8,10-12, 16-21 |
| A | WO 2007/004575 A1  (Mitsui Chemicals, Inc.), 11 January, 2007 (11.01.07), Par. Nos. [0055] to [0074], [0076] to [0090]; Figs. 1 to 6 & EP 1901097 A1 | 16,17 |
| A | JP 2006-38962 A  (Nitto Denko Corp.), 09 February, 2006 (09.02.06), Par. Nos. [0034] to [0047] (Family: none) | 16,17 |
| A | JP 2001-102700 A  (Sanyo Electric Co., Ltd.), 13 April, 2001 (13.04.01), Par. Nos. [0023] to [0034]; Figs. 1, 2 (Family: none) | 16,17 |
| A | JP 2006-313389 A  (Hitachi Chemical Co., Ltd.), 16 November, 2006 (16.11.06), Par. Nos. [0025] to [0033] & US 2005/0002631 A1    & WO 2003/058306 A1 & CN 1608219 A | 16,17 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005156882 A
- JP 2006284925 A